# EUROPEAN PATENT APPLICATION

(11) **EP 4 693 904 A1**
(43) Date of publication of application: **11.02.2026**
(21) Application number: 24203559.0
(22) Date of filing: 30.09.2024
(51) Int. Cl.: H03K 17/18, G01R 31/26

(54) **SYSTEM AND METHOD FOR GATE THRESHOLD VOLTAGE MEASUREMENT**

(30) Priority: 07.08.2024 US 202418796826
(71) Applicant: Semiconductor Components Industries, LLC, Scottsdale, AZ 85250 (US)
(72) Inventor: DUBRAVKA, Peter, 01815 Precin (SK); RENDEK, Karol, 02061 Lednické Rovne (SK)
(74) Representative: Manitz Finsterwald Patent- und Rechtsanwaltspartnerschaft mbB

(57) **Abstract**

A measurement circuit is disclosed. The measurement circuit may include a current source configured to provide a current to a drain terminal of a transistor. The measurement circuit may also include a voltage-measure circuit configured to measure a drain-to-source voltage of the transistor. The measurement circuit may further include a regulator circuit. The regulator circuit may be configured to receive from the voltage-measure circuit a voltage-measure signal indicative of the drain-to-source voltage of the transistor, and to regulate the gate-to-source voltage of the transistor based on the drain-to-source voltage of the transistor.

## Description

### TECHNICAL FIELD

The disclosure relates generally to integrated circuit technology, and particularly to measurement of a threshold voltage for a transistor.

### BACKGROUND

Power transistors may be utilized in various power electronics applications, such as in a driver for an electric motor. In such applications, the continued thermal cycling associated with repeatedly turning on and off the power transistor may lead to the degradation of the power transistor. For example, the continued thermal cycling of a power transistor may degrade the gate oxide of the power transistor, eventually leading to failure.

The inventors of embodiments of the present disclosure have recognized that certain electrical characteristics of a power transistor, such as the gate threshold voltage, may be indicative of device degradation and thus predictive of potential future failure. The inventors of embodiments of the present disclosure have also recognized that the ability to monitor certain electrical characteristics of a power transistor, while still coupled within the higher-level application circuit, may be limited. Embodiments of the present disclosure may address one or more of these challenges.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a schematic diagram of a gate threshold test circuit in accordance with embodiments of the present disclosure.
FIG. 2 illustrates a schematic diagram of a motor drive circuit in accordance with embodiments of the present disclosure.
FIG. 3 illustrates a block diagram of a measurement circuit in accordance with embodiments of the present disclosure.
FIG. 4 illustrates a schematic diagram of a measurement circuit in accordance with embodiments of the present disclosure.
FIG. 5 illustrates operation of a method for measuring a gate threshold voltage of a transistor in accordance with embodiments of the present disclosure.

### DETAILED DESCRIPTION

Details of one or more embodiments are set forth in the description below and the accompanying drawings. Other features will be apparent from the description, drawings, and from the claims.

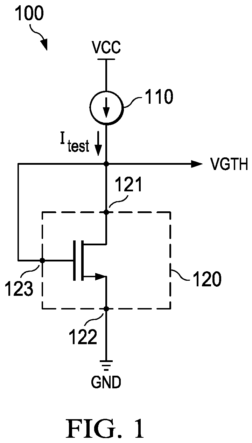

FIG. 1 illustrates a schematic diagram of gate threshold test circuit 100 in accordance with embodiments of the present disclosure. Gate threshold test circuit 100 may include current source 110 and transistor 120. Current source 110 may be configured to provide a test current Iₜₑₛₜ with a value of, for example, 1 mA, 10 mA, 50 mA, 100 mA, 150 mA, 200 mA, 250 mA, or more. Transistor 120 may include drain terminal 121, source terminal 122, and gate terminal 123. To test the gate threshold voltage of transistor 120, current source 110 may be coupled to provide the test current Iₜₑₛₜ to drain terminal 121 of transistor 120, gate terminal 123 may be coupled to drain terminal 121, and source terminal 122 may be coupled to ground GND. By coupling gate terminal 123 to drain terminal 121, a bias voltage may be generated at gate terminal 123 sufficient to drive transistor 120 at a level sufficient to sink the test current Iₜₑₛₜ from current source 110. The level of the bias voltage required at gate terminal 123 to drive transistor 120 to sink a given value of the test current Iₜₑₛₜ may be referred to as the gate threshold voltage VGTH of transistor 120.

The gate threshold voltage VGTH of a transistor may change over the life of the transistor. For example, during repeated use in high-power applications, the gate oxide of a transistor such as transistor 120 may degrade over time. Degradation of the gate oxide may in turn cause the gate threshold voltage VGTH of a transistor such as transistor 120 to increase. The inventors of embodiments of the present disclosure have recognized that it would be beneficial to test the gate threshold voltage VGTH of a transistor, such as transistor 120, throughout the life of the transistor when included in a high-power application.

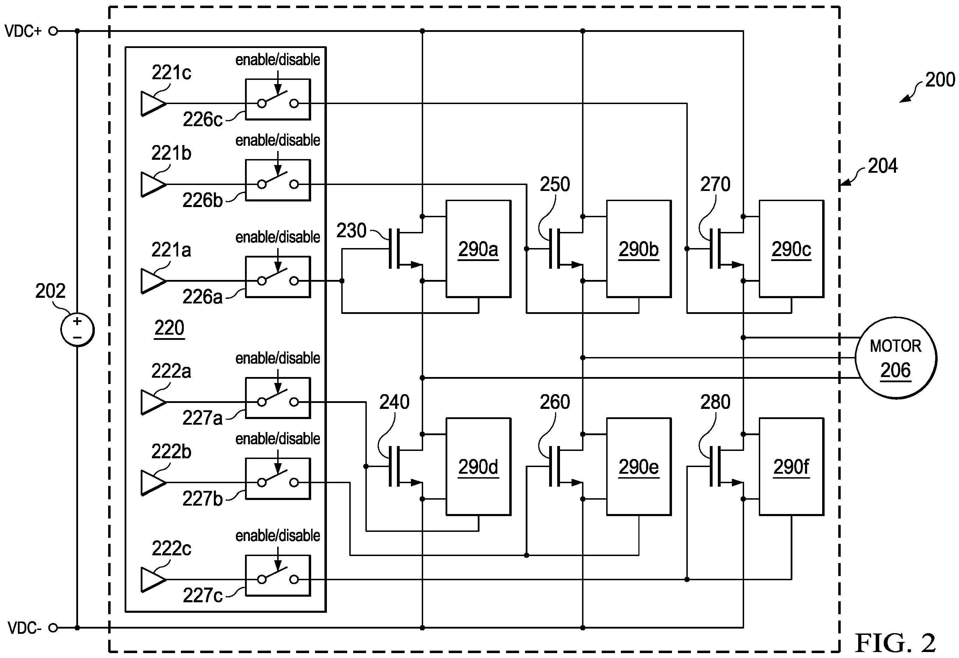

FIG. 2 illustrates a schematic diagram of motor drive circuit 200 in accordance with embodiments of the present disclosure. Motor drive circuit 200 may include DC voltage source 202, inverter circuit 204, and motor 206. Motor 206 may be an electric motor. DC voltage source 202 may provide a DC voltage of for example, 400 V, 800 V, or more, across a positive supply rail VDC+ and a negative supply rail VDC-. Inverter circuit 204 may include a plurality of transistors configured to drive motor 206. For example, inverter circuit 204 may include transistors 230, 240, 250, 260, 270, and 280. As shown in FIG. 2, inverter circuit 204 may be configured as a three-phase inverter. For example, transistors 230 and 240 may be coupled in series between VDC+ and VDC- to form a first half bridge to drive motor 206, transistors 250 and 260 may be coupled in series between VDC+ and VDC- to form a second half bridge to drive motor 206, and transistors 270 and 280 may be coupled in series between VDC+ and VDC- to form a third half bridge to drive motor 206.

Inverter circuit 204 may also include gate drive circuit 220. Gate drive circuit 220 may include a plurality of gate drivers 221 and 222 and a plurality of corresponding switches 226 and 227. The plurality of gate drivers 221 and 222 may be configured to respectively drive the plurality of transistors during an operating phase of inverter circuit 204. For example, gate drive circuit 220 may include gate driver 221a coupled to drive a gate of transistor 230 via switch 226a, gate driver 221b coupled to drive a gate of transistor 250 via switch 226b, and gate driver 221c coupled to drive a gate of transistor 270 via switch 226c. For the purposes of the present disclosure, each of gate drivers 221a-c may also be referred to as high-side gate drivers. Further, gate drive circuit 220 may include gate driver 222a coupled to drive a gate of transistor 240 via switch 227a, gate driver 222b coupled to drive a gate of transistor 260 via switch 227b, and gate driver 222c coupled to drive a gate of transistor 280 via switch 227c. For the purposes of the present disclosure, each of gate drivers 222a-c may also be referred to as low-side gate drivers. During an operating phase of inverter circuit 204, switches 226a-c and 227a-c may be enabled such that switches 226a-c and 227a-c are each in an on-state, thereby allowing gate drivers 221a-c and gate drivers 222a-c to drive their respective transistors. For example, during the operating phase of inverter circuit 204, gate drivers 221a-c and gate drivers 222a-c may drive their respective transistors, including transistors 230, 250, and 270, and transistors 240, 260, and 280, on and off in a coordinated and repeated manner to provide a three-phase drive to motor 206. Although switches 226a-c and 227a-c are shown in the example embodiment illustrated in FIG. 2 as being included within gate drive circuit 220, switches 226a-c and 227 a-c may also in some embodiments be implemented separate from gate drive circuit 220.

Inverter circuit 204 may also include a plurality of measurement circuits 290a, 290b, 290c, 290d, 290e, 290f (collectively, measurement circuits 290). In some embodiments, each of the plurality of measurement circuits 290 may be configured to measure the gate threshold voltage of a respective one of the plurality of transistors, including transistors 230, 240, 250, 260, 270, and 280, during an initialization phase of inverter circuit 204. For example, as shown in FIG. 2, measurement circuit 290a may be configured to measure the gate threshold voltage of transistor 230, measurement circuit 290b may be configured to measure the gate threshold voltage of transistor 250, measurement circuit 290c may be configured to measure the gate threshold voltage of transistor 270, measurement circuit 290d may be configured to measure the gate threshold voltage of transistor 240, measurement circuit 290e may be configured to measure the gate threshold voltage of transistor 260, and measurement circuit 290f may be configured to measure the gate threshold voltage of transistor 280.

Prior to an operating phase of inverter circuit 204 where inverter circuit 204 drives motor 206, inverter circuit 204 may proceed through an initialization phase. During this initialization phase, the gate threshold of one or more of transistors 230, 240, 250, 260, 270, and 280 may be measured. For example, the gate threshold of transistors 230, 240, 250, 260, 270, and 280 may be measured one at a time. When the gate threshold voltage of one transistor is being measured, the other transistors may be held in an off-state so as to not interfere with the measurement of the one transistor. Further, the gate driver corresponding to the switch under test may be disabled so as to block the corresponding gate driver from interfering with the gate threshold voltage measurement. For example, when the gate threshold voltage of transistor 230 is being measured during the initialization phase of inverter circuit 204, switch 226a may be placed in off-state to effectively disable gate driver 221a and thereby prevent gate driver 221a from interfering with the gate threshold voltage measurement of transistor 230 by measurement circuit 290a. Further, transistors 240, 250, 260, 270, and 280 may each be held by their respective gate drivers in an off-state so as to not interfere with the measurement of the gate threshold voltage of transistor 230.

In some embodiments, the gate threshold voltages of each of transistors 230, 240, 250, 260, 270, and 280 may be measured one at a time and reported to a processing unit (not shown in FIG. 2) during the initialization phase of inverter circuit 204. The measured values of the respective gate thresholds may be compared to an expected value. A larger-than-expected gate threshold voltage value may indicate, for example, the degradation of, and potential future failure of, the measured transistor.

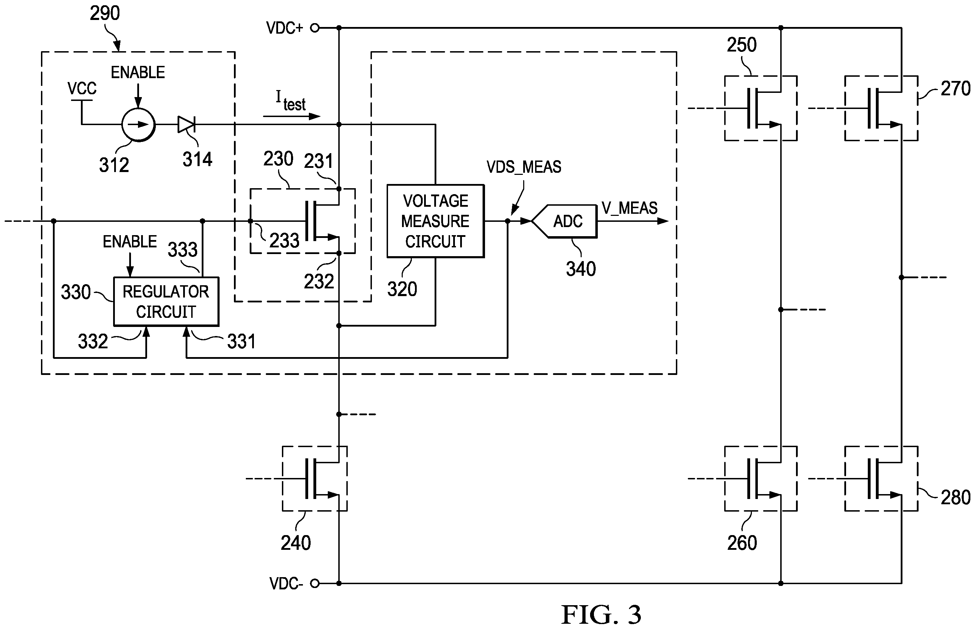

After the initialization phase, inverter circuit 204 may proceed to an operating phase. During the operating phase, gate drivers 221a-c and 222a-c of gate drive circuit 220 may turn on and off transistors 230, 240, 250, 260, 270, and 280 in a repeating and coordinated manner to provide a three-phase drive to motor 206. As described in further detail below with reference to FIG. 3, the respective measurement circuits 290 may, in addition to measuring the gate threshold voltages of transistors 230, 240, 250, 260, 270, and 280 during the initialization phase of inverter circuit 204, measure the on-state drain-to-source voltage of transistors 230, 240, 250, 260, 270, and 280 during the operating phase of inverter circuit 204. The drain-to-source voltages of transistors 230, 240, 250, 260, 270, and 280 may be reported to a processing unit (not shown in FIG. 2). And like the measured gate threshold voltages, a measured on-state drain-to-source voltage different from an expected on-state drain-to-source voltage may indicate a degradation and potential future failure of the measured transistor.

In some embodiments, the transistors of inverter circuit 204, including transistors 230, 240, 250, 260, 270, and 280 may each comprise a metal-oxide semiconductor field-effect transistor (MOSFET). Transistors 230, 240, 250, 260, 270, and 280 may each comprise, for example, a silicon-carbide (SiC) MOSFET. In other embodiments, the transistors of inverter circuit 204, including transistors 230, 240, 250, 260, 270, and 280 may each comprise a silicon insulated-gate bipolar transistor (IGBT). An IGBT may be referred to as having a gate terminal, a collector terminal, and an emitter terminal, as opposed to the respective gate terminal, drain terminal, and source terminal of a MOSFET. However, the principles of the embodiments of the present disclosure may apply equally regardless of whether transistors 230, 240, 250, 260, 270, and 280 are implemented as MOSFETs or as IGBTs. Thus, for the purposes of the present disclosure, the term "drain" or "drain terminal" may refer to either the drain or drain terminal of a MOSFET or the collector or collector terminal of an IGBT. Further, for the purposes of the present disclosure, the term "source" or "source terminal" may refer to either the source or source terminal of a MOSFET or the emitter or emitter terminal of an IGBT. For example, terms such as the "drain-to-source" voltage of a transistor may, for the purposes of the present disclosure, refer to either the drain-to-source voltage of a MOSFET or the collector-to-emitter voltage of an IGBT. Likewise, terms such as "gate-to-source" voltage of a transistor may, for the purposes of the present disclosure, refer to either the gate-to-source voltage of a MOSFET or the gate-to-emitter voltage of an IGBT.

In some embodiments, one or more instances of measurement circuit 290 may be implemented on either a separate semiconductor die or on the same monolithic semiconductor die as one or more gate drivers, such as high-side gate drivers 221a-c and low-side gate drivers 222a-c of gate drive circuit 220. In embodiments where one or more instances of measurement circuit 290 may be implemented on a separate semiconductor die from the respective one or more gate drivers, the one or more instances of measurement circuit 290 may be co-packaged with one or more respective gate drivers in the same multi-die integrated circuit package. In addition, the one or more instances of measurement circuit 290 and corresponding gate drivers, whether implemented on the same monolithic semiconductor die or on separate semiconductor dice, may be further co-packaged within the one or more transistors, such as transistors 230, 240, 250, 260, 270, and 280, in a multi-die integrated circuit package.

FIG. 3 illustrates a block diagram of an instance of measurement circuit 290 in accordance with embodiments of the present disclosure. For simplicity, a single instance of measurement circuit 290 is shown in FIG. 3. But as described above with reference to FIG. 2, separate instances of measurement circuit 290 may be utilized to measure the gate threshold voltages of each of transistors 230, 240, 250, 260, 270, and 280. Moreover, although measurement circuit 290 may be described herein as measuring the gate threshold voltage (and the on-state drain-to-source voltage) of transistors such as transistors 230, 240, 250, 260, 270, and 280 included within inverter circuit 204, measurement circuit 290 may also be utilized to measure the gate threshold voltage of transistors included in other forms of power electronics, such as transistors used in a half-bridge or a full-bridge power converter topologies or in other motor driver topologies.

Measurement circuit 290 may be implemented in any suitable fashion according to the operation described in the present disclosure. In some embodiments, measurement circuit 290 may include current source 312, diode 314, voltage-measure circuit 320, and regulator circuit 330. In some embodiments, measurement circuit 290 may also include analog-to-digital converter 340.

Current source 312 may be configured to provide a test current Iₜₑₛₜ with a value of, for example, 1 mA, 10 mA, 50 mA, 100 mA, 150 mA, 200 mA, 250 mA, or more. As shown in FIG. 3, current source 312 may be coupled in series with diode 314, which may in turn be coupled to drain terminal 231 of transistor 230. When enabled by an ENABLE signal, current source 312 may thus provide the test current Iₜₑₛₜ to drain terminal 231. Although current source 312 and diode 314 are shown in FIG. 3 as separate from voltage-measure circuit 320, current source 312 and diode 314 may also be considered part of voltage-measure circuit 320. Voltage-measure circuit 320 may be coupled across transistor 230, with a first terminal coupled to drain terminal 231 of transistor 230 and a second terminal coupled to source terminal 232 of transistor 230. Voltage-measure circuit 320 may measure the drain-to-source voltage of transistor 230 and provide a voltage-measure signal VDS_MEAS. As described above with reference to FIG. 2, when the gate threshold voltage of transistor 230 is being measured, the other transistors of inverter circuit 204, including transistors 240, 250, 260, 270, and 280 may be held in an off-state. Thus, the electrical node connected to source terminal 232 of transistor 230 may serve as a floating ground for voltage-measure circuit 320 and other components within the instance of measurement circuit 290 coupled to transistor 230.

Regulator circuit 330 may include reference input 331, feedback input 332, and gate-drive output 333. Regulator circuit 330 may also include an enable input and may be configured to regulate the gate-to-source voltage of transistor 230 based on the drain-to-source voltage of transistor 230 in response to an ENABLE signal received at the enable input. When enabled, regulator circuit 330 may be configured to drive gate terminal 233 of transistor 230 based on a comparison of reference input 331 to feedback input 332. For example, regulator circuit 330 may be configured to receive, from voltage-measure circuit 320, the voltage-measure signal VDS_MEAS indicative of the drain-to-source voltage of transistor 230. Specifically, regulator circuit 330 may receive voltage-measure signal VDS_MEAS at reference input 331, and the voltage-measure signal VDS_MEAS may thus serve as a reference voltage for regulating the gate-to-source voltage of transistor 230. Gate-drive output 333 may be coupled to gate terminal 233 of transistor 230. Feedback input 332 may also be coupled to gate terminal 233 of transistor 230. Based on the comparison of the feedback received at feedback input 332 to the voltage-measure signal VDS_MEAS received at reference input 331, regulator circuit 330 may drive the gate terminal 233 of transistor 230 to have the same value as VDS_MEAS. Specifically, regulator circuit 330 may in some embodiments regulate the gate-to-source voltage of transistor 230 to be equal to the drain-to-source voltage of transistor 230 as represented by VDS_MEAS. With the gate-to-source voltage regulated to be equal to the drain-to-source voltage, gate terminal 233 of transistor 230 may be driven at a voltage level sufficient to sink the test current Iₜₑₛₜ received at drain terminal 231.

By regulating the gate-to-source voltage of transistor 230 to be equal to the drain-to-source voltage of transistor 230, the measured drain-to-source voltage VDS_MEAS may also represent a measure of the gate threshold voltage of transistor 230 at the given value of the test current Iₜₑₛₜ. Measurement circuit 290 may thus be utilized to measure the gate threshold voltage of transistor 230 when transistor 230 is included among other devices within a power application such as inverter circuit 204.

In some embodiments, measurement circuit 290 may also include analog-to-digital converter 340. As shown in FIG. 3, analog-to-digital converter 340 may be coupled to voltage-measure circuit 320. Analog-to-digital converter 340 may be configured to receive the voltage-measure signal VDS_MEAS and to output a digital signal V_MEAS corresponding to the analog value of the voltage-measure signal VDS_MEAS. The digital signal V_MEAS may thus represent the gate threshold voltage of transistor 230 when current source 312 and regulator circuit 330 are enabled. As described above with reference to FIG. 2, this gate threshold voltage may be measured during an initialization phase of inverter circuit 204 and may be reported upstream to a processing unit for comparison against an expected gate threshold voltage value.

In some embodiments, voltage-measure circuit 320 may also be utilized to measure the on-state drain-to-source voltage of transistor 230 during the operating phase of inverter circuit 204. For example, during the operating phase of inverter circuit 204, the ENABLE signal may be deasserted to disable current source 312 and regulator circuit 330. During the operating phase, transistor 230 may be switched on and off repeatedly by gate driver 221a of gate drive circuit 220, as described above with reference to FIG. 2. During an on-state of transistor 230, voltage-measure circuit 320 may measure the drain-to-source voltage of transistor 230. The voltage-measure signal VDS_MEAS during this on-state may thus represent the on-state drain-to-source voltage of transistor 230. Analog-to-digital converter 340 may continue to receive the voltage-measure signal VDS_MEAS and continue to provide a digital signal V_MEAS corresponding to the analog value of VDS_MEAS. Thus, during the operating phase of inverter circuit 204, the digital signal V_MEAS may represent the on-state drain-to-source voltage of transistor 230. And as described above with reference to FIG. 2, this on-state drain-to-source voltage may be measured during the operating phase of inverter circuit 204 and may be reported upstream to a processing unit for comparison against an expected on-state drain-to-source voltage value.

Accordingly, measurement circuit 290 may provide for a single circuit that may measure and report both the gate threshold voltage of transistor 230 and the on-state drain-to-source voltage of transistor 230. For example, the voltage-measure signal VDS_MEAS may correspond to the gate threshold voltage of transistor 230 when regulator circuit 330 is enabled. Further, the voltage-measure signal VDS_MEAS may correspond to an on-state drain-to-source voltage of transistor 230 when transistor 230 is driven by gate driver 221a in an on-state and regulator circuit 330 is disabled.

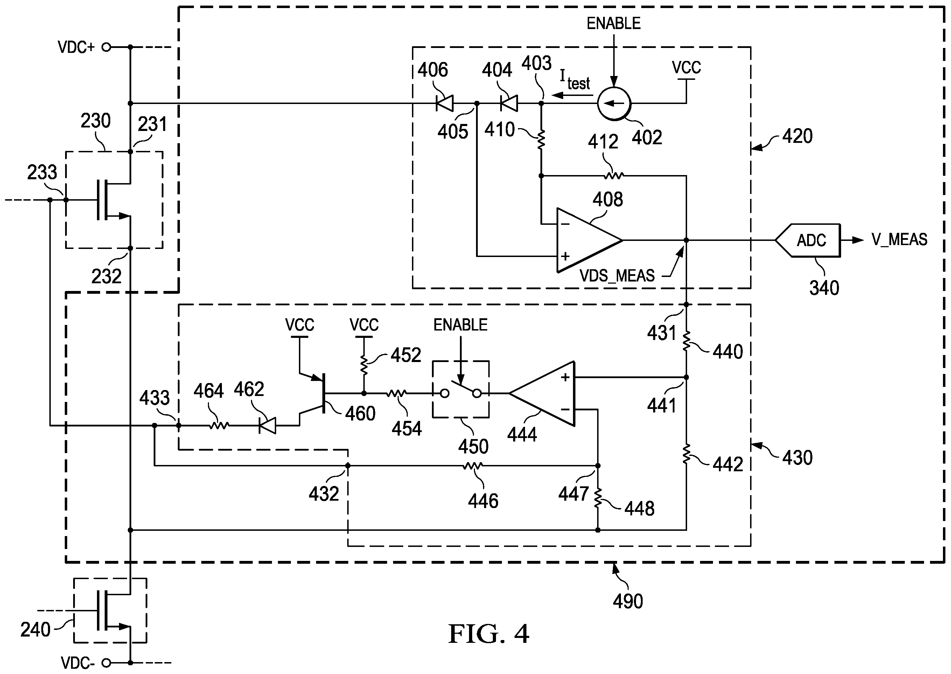

FIG. 4 illustrates a schematic diagram of an instance of measurement circuit 490 in accordance with embodiments of the present disclosure. Measurement circuit 490 may serve as an embodiment of measurement circuit 290 described above with reference to FIG. 2 and FIG. 3. For simplicity, a single instance of a schematic diagram of measurement circuit 490 is shown in FIG. 4. But similar to the description above with reference to FIG. 2, separate instances of measurement circuits, such as measurement circuit 490, may be utilized to measure the gate threshold voltages of each of transistors 230, 240, 250, 260, 270, and 280. Moreover, although measurement circuit 490 may be described herein as measuring the gate threshold voltage (and the on-state drain-to-source voltage) of transistors such as transistors 230, 240, 250, 260, 270, and 280 included within inverter circuit 204, measurement circuit 490 may also be utilized to measure the gate threshold voltage (and on-state drain-to-source voltage) of transistors included in other forms of power electronics, such as transistors used in half-bridge or full-bridge power converter topologies or other motor driver topologies.

Measurement circuit 490 may be implemented in any suitable fashion according to the operation described in the present disclosure. In some embodiments, measurement circuit 490 may include voltage-measure circuit 420 and regulator circuit 430. In some embodiments, measurement circuit 490 may also include analog-to-digital converter 340.

Voltage-measure circuit 420 may serve as an embodiment of voltage-measure circuit 320 described above with reference to FIG. 3. Voltage-measure circuit 420 may be implemented in any suitable fashion according to the operation described in the present disclosure. In some embodiments, voltage-measure circuit 420 may include current source 402, diode 404, diode 406, amplifier 408, resistor 410, and resistor 412.

Current source 402 may be configured to provide a test current Iₜₑₛₜ with a value of, for example, 1 mA, 10 mA, 50 mA, 100 mA, 150 mA, 200 mA, 250 mA, or more. As shown in FIG. 4, current source 402 may be coupled in series with diode 404 and diode 406, which may in turn be coupled to drain terminal 231 of transistor 230. When enabled by an ENABLE signal, current source 402 may thus provide the test current Iₜₑₛₜ to drain terminal 231 via diode 404 and diode 406. Amplifier 408 may be utilized to measure the drain-to-source voltage of transistor 230. For example, amplifier 408 may have a positive input terminal coupled to node 405 between diode 404 and diode 406. Amplifier 408 may also have a negative input terminal coupled via resistor 410 to node 403 between current source 402 and diode 404. Resistor 412 may be coupled between the output terminal of amplifier 408 and the negative input terminal of amplifier 408. Amplifier 408 may compare the voltages at its positive and negative input terminals, and may provide an output voltage that forces its negative input terminal to equal its positive input terminal. The voltage across resistor 410 may thus be equal to the voltage drop across diode 404. Moreover, resistor 412 may have the same resistance value as resistor 410, and diode 406 may be configured to have the same voltage drop as diode 404. Accordingly, the feedback network formed by resistors 410 and 412 may cancel out the forward voltage drops of diodes 404 and 406. The output of amplifier 408 may thus provide a voltage-measure signal VDS_MEAS equal to the drain-to-source voltage of transistor 230.

As described above with reference to FIG. 2, when the gate threshold voltage of transistor 230 is being measured, the other transistors of inverter circuit 204, including transistors 240, 250, 260, 270, and 280 may be held in an off-state. Thus, the electrical node coupled to source terminal 232 of transistor 230 may serve as a floating ground for voltage-measure circuit 420 and other components within the instance of measurement circuit 490 coupled to transistor 230.

Regulator circuit 430 may serve as an embodiment of regulator circuit 330 described above with reference to FIG. 3. Regulator circuit 430 may be implemented in any suitable fashion according to the operation described in the present disclosure. In some embodiments, regulator circuit 430 may include reference input 431, feedback input 432, and gate-drive output 433. Regulator circuit may also include resistor 440, resistor 442, amplifier 444, resistor 446, resistor 448, switch 450, resistor 452, resistor 454, transistor 460, diode 462, and resistor 464.

Reference input 431 may be coupled to receive the voltage-measure signal VDS_MEAS from voltage-measure circuit 420. Resistor 440 and resistor 442 may be coupled in series between reference input 431 and the floating ground coupled to source terminal 232 of transistor 230. Amplifier 444 may have a positive input terminal connected to the intermediate node 441 between resistor 440 and resistor 442, and may thus receive a divided voltage proportional to VDS_MEAS. Feedback input 432 may be coupled to receive the gate voltage applied to gate terminal 233 of transistor 230. Resistor 446 and resistor 448 may be coupled in series between feedback input 432 and the floating ground coupled to source terminal 232 of transistor 230. Amplifier 444 may have a negative input terminal connected to the intermediate node 447 between resistor 446 and resistor 448, and may thus receive a divided voltage proportional to the gate-to-source voltage of transistor 230. Amplifier 444 may compare the voltages at its positive and negative input terminals and provide an amplifier output voltage to transistor 460 via switch 450 and resistor 454.

As shown in FIG. 4, the output of amplifier 444 may be coupled to the base of transistor 460 via switch 450 and resistor 454. When regulator circuit 430 is enabled by the ENABLE signal, switch 450 may pass the output of amplifier to the base of transistor 460 via resistor 454. As shown in FIG. 4, resistor 452 may be coupled between voltage supply VCC, and resistor 454 may be coupled between switch 450 and the base of transistor 460. In some embodiments, transistor 460 may be a P-type bipolar junction transistor (P-type BJT or PNP transistor). Transistor 460 may have an emitter coupled to voltage supply VCC, a base coupled to the output of amplifier 444 via switch 450 and resistor 452, and a collector coupled to gate-drive output 433 via diode 462 and resistor 464. Thus, when regulator circuit 430 is enabled by the ENABLE signal, transistor 460 may drive gate-drive output 433 according to the amplifier output voltage of amplifier 444.

In some embodiments, a first ratio of the resistance values of resistor 440 to resistor 442 may be equal to a second ratio of the resistance values of resistor 446 to resistor 448. Accordingly, the voltage division provided by resistors 440 and 442 to the positive input terminal of amplifier 444 may be equal to the voltage division provided by resistors 446 and 448 to the negative input terminal of amplifier 444. The gate drive voltage provided by regulator circuit 430 at gate-drive output 433 (and fed back to amplifier 444 via feedback input 432 and resistors 446 and 448) may thus be equal to the voltage of the voltage-measure signal VDS_MEAS. As shown in FIG. 4, gate-drive output 433 may be coupled to gate terminal 233 of transistor 230. Accordingly, regulator circuit 430 may regulate the gate-to-source voltage of transistor 230 to be equal to the drain-to-source voltage of transistor 230 when regulator circuit 430 is enabled by the ENABLE signal.

By regulating the gate-to-source voltage of transistor 230 to be equal to the drain-to-source voltage of transistor 230, the measured drain-to-source voltage VDS_MEAS may also represent a measure of the gate threshold voltage of transistor 230 at the given value of the test current Iₜₑₛₜ. Measurement circuit 490 may thus be utilized to measure the gate threshold voltage of transistor 230 when transistor 230 is included among other devices within a power application such as inverter circuit 204.

In some embodiments, measurement circuit 490 may also include analog-to-digital converter 340. As shown in FIG. 4, analog-to-digital converter 340 may be coupled to voltage-measure circuit 420. Analog-to-digital converter 340 may be configured to receive the voltage-measure signal VDS_MEAS and to output a digital signal V_MEAS corresponding to the analog value of the voltage-measure signal VDS_MEAS. The digital signal V_MEAS may thus represent the gate threshold voltage of transistor 230 when regulator circuit 430 is enabled. As described above with reference to FIG. 2, this gate threshold voltage may be measured during an initialization phase of inverter circuit 204 and may be reported upstream to a processing unit for comparison against an expected gate threshold voltage value.

In some embodiments, voltage-measure circuit 420 may also be utilized to measure the on-state drain-to-source voltage of transistor 230 during the operating phase of inverter circuit 204. For example, during the operating phase of inverter circuit 204, the ENABLE signal may be deasserted to disable regulator circuit 430. During the operating phase, transistor 230 may be switched on and off repeatedly by gate driver 221a of gate drive circuit 220, as described above with reference to FIG. 2. During an on-state of transistor 230, voltage-measure circuit 420 may measure the drain-to-source voltage of transistor 230. The voltage-measure signal VDS_MEAS during this on-state may thus represent the on-state drain-to-source voltage of transistor 230. Analog-to-digital converter 340 may continue to receive the voltage-measure signal VDS_MEAS and continue to provide a digital signal V_MEAS corresponding to the analog value of VDS_MEAS. Thus, during the operating phase of inverter circuit 204, the digital signal V_MEAS may represent the on-state drain-to-source voltage of transistor 230. And as described above with reference to FIG. 2, this on-state drain-to-source voltage may be measured during the operating phase of inverter circuit 204 and may be reported upstream to a processing unit for comparison against an expected on-state drain-to-source voltage value.

Accordingly, measurement circuit 490 may provide for a single circuit that may measure and report both the gate threshold voltage of transistor 230 and the on-state drain-to-source voltage of transistor 230. For example, the voltage-measure signal VDS_MEAS may correspond to the gate threshold voltage of transistor 230 when regulator circuit 430 is enabled. Further, the voltage-measure signal VDS_MEAS may correspond to an on-state drain-to-source voltage of transistor 230 when transistor 230 is driven by gate driver 221a in an on-state and regulator circuit 330 is disabled.

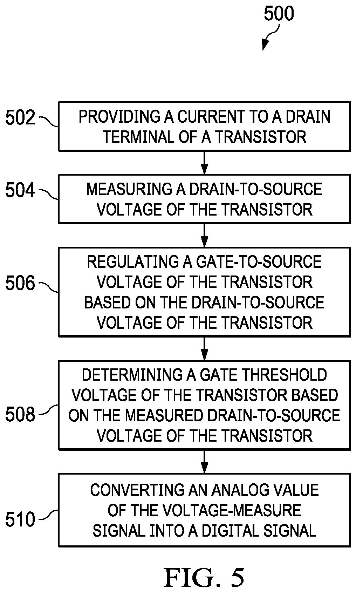

FIG. 5 illustrates the operation of method 500 for measuring a gate threshold voltage of a transistor in accordance with embodiments of the present disclosure. Method 500 may be performed by any suitable mechanism, such as measurement circuit 290, measurement circuit 490, or any combination of components thereof. Method 500 may be performed with fewer or more steps than shown in FIG. 5. Moreover, steps of method 500 may be omitted, repeated, performed in parallel, performed in a different order than shown in FIG. 5, or performed recursively. One or more steps of method 5, although shown in an order, may be performed at the same time or in a re-ordered manner.

Step 502 may include providing a current to a drain terminal of a transistor. For example, as described above with reference to FIG. 3, current source 312 may provide a test current Iₜₑₛₜ to transistor 230 via diode 314. As another example, as described above with reference to FIG. 4, current source 402 may provide a test current Iₜₑₛₜ to transistor 230 via diode 404 and diode 406.

Step 504 may include measuring a drain-to-source voltage of the transistor. For example, as described above with reference to FIG. 3, voltage-measure circuit 320 may measure the drain-to-source voltage of transistor 230. Voltage-measure circuit 320 may further perform the step of generating a voltage-measure signal VDS_MEAS based on the measured drain-to-source voltage of transistor 230. As another example, and as described above with reference to FIG. 4, voltage-measure circuit 420 may measure the drain-to-source voltage of transistor 230. Voltage-measure circuit 420 may further perform the step of generating a voltage-measure signal VDS_MEAS based on the measured drain-to-source voltage of transistor 230.

Step 506 may include regulating a gate-to-source voltage of the transistor based on the drain-to-source voltage of the transistor. For example, as described above with reference to FIG. 3, regulator circuit 330 may regulate the gate-to-source voltage of transistor 230 to be equal to the drain-to-source voltage of transistor 230 as represented by the voltage-measure signal VDS_MEAS from voltage-measure circuit 320. Specifically, regulator circuit 330 may perform the act of driving gate terminal 233 of transistor 230 based on a comparison of a gate voltage received at feedback input 332 to the voltage-measure signal VDS_MEAS received at reference input 331. As another example, and as described above with reference to FIG. 4, regulator circuit 430 may regulate the gate-to-source voltage of transistor 230 based on the drain-to-source voltage of transistor 230 as represented by the voltage-measure signal VDS_MEAS from voltage-measure circuit 420.

Step 508 may include determining a gate threshold voltage of the transistor based on the measured drain-to-source voltage of the transistor. For example, as described above with reference to FIG. 3 and FIG. 4, by regulating the gate-to-source voltage of transistor 230 to be equal to the drain-to-source voltage of 230, the voltage-measure signal VDS_MEAS indicative of the drain-to-source voltage may also be representative of the gate threshold voltage of transistor 230.

Step 510 may include converting an analog value of the voltage-measure signal into a digital signal. For example, as described above with reference to FIG. 3 and FIG. 4, analog-to-digital converter 340 may generate a digital signal V_MEAS based on an analog value of the voltage-measure signal VDS_MEAS.

Embodiments herein may include a measurement circuit. The measurement circuit includes a current source configured to provide a current to a drain terminal of a transistor. The measurement circuit further includes a voltage-measure circuit configured to measure a drain-to-source voltage of the transistor. In addition, the measurement circuit includes a regulator circuit configured to receive from the voltage-measure circuit a voltage-measure signal indicative of the drain-to-source voltage of the transistor, and to regulate a gate-to-source voltage of the transistor based on the drain-to-source voltage of the transistor. The measurement circuit may have one or more of the following additional elements in any combination. Element 1: wherein the regulator circuit is configured to regulate the gate-to-source voltage of the transistor to be equal to the drain-to-source voltage of the transistor. Element 2: wherein the regulator circuit comprises an enable input and is configured to regulate the gate-to-source voltage of the transistor based on the drain-to-source voltage of the transistor in response to an enable signal received at the enable input. Element 3: wherein the voltage-measure signal corresponds to a gate threshold voltage of the transistor when the regulator circuit is enabled. Element 4: wherein the voltage-measure signal corresponds to an on-state drain-to-source voltage of the transistor when the transistor is driven in an on-state and the regulator circuit is disabled. Element 5: wherein the regulator circuit comprises: a reference input coupled to receive the voltage-measure signal, a gate-drive output coupled to a gate terminal of the transistor, and a feedback input coupled to the gate terminal of the transistor, wherein the regulator circuit is configured to drive the gate terminal of the transistor based on a comparison of the reference input to the feedback input. Element 6: wherein the measurement circuit further comprises an analog-to-digital converter coupled to the voltage-measure circuit and configured to output a digital signal corresponding to an analog value of the voltage-measure signal.

Embodiments herein may include an inverter circuit. The inverter circuit includes a plurality of transistors configured to drive an electric motor. The inverter circuit further includes a gate drive circuit including a plurality of gate drivers configured to respectively drive the plurality of transistors during an operating phase of the inverter circuit. In addition, the inverter circuit includes a measurement circuit configured to measure a gate threshold voltage of a transistor from among the plurality of transistors during an initialization phase of the inverter circuit. The measurement circuit comprises a current source configured to provide a current to a drain terminal of the transistor, a voltage-measure circuit configured to measure a drain-to-source voltage of the transistor, and a regulator circuit. The regulator circuit is configured to receive from the voltage-measure circuit a voltage-measure signal indicative of the drain-to-source voltage of the transistor, and to regulate a gate-to-source voltage of the transistor based on the drain-to-source voltage of the transistor. The inverter circuit may have one or more of the following additional elements in any combination. Element 1: wherein the inverter circuit includes a plurality of measurement circuits, each of the plurality of measurement circuits is configured to measure the gate threshold voltage of a respective one of the plurality of transistors during the initialization phase of the inverter circuit. Element 2: wherein each transistor of the plurality of transistors comprises a silicon-carbide (SiC) metal-oxide semiconductor field-effect transistor (MOSFET). Element 3: wherein each transistor of the plurality of transistors comprises a silicon insulated-gate bipolar transistor (IGBT). Element 4: wherein the regulator circuit comprises an enable input and is configured to regulate the gate-to-source voltage of the transistor based on the drain-to-source voltage of the transistor in response to an enable signal received at the enable input. Element 5:
wherein the voltage-measure signal corresponds to a gate threshold voltage of the transistor when the regulator circuit is enabled. Element 6: wherein the voltage-measure signal corresponds to an on-state drain-to-source voltage of the transistor when the transistor is driven in an on-state and the regulator circuit is disabled. Element 7: wherein the regulator circuit comprises a reference input coupled to receive the voltage-measure signal, a gate-drive output coupled to a gate terminal of the transistor, and a feedback input coupled to the gate terminal of the transistor, wherein the regulator circuit is configured to drive the gate terminal of the transistor based on a comparison of the reference input to the feedback input. Element 8: wherein the inverter circuit further comprising an analog-to-digital converter coupled to the voltage-measure circuit and configured to output a digital signal corresponding to an analog value of the voltage-measure signal.

Embodiments herein may include a method comprising providing a current to a drain terminal of a transistor, measuring a drain-to-source voltage of the transistor, regulating a gate-to-source voltage of the transistor based on the drain-to-source voltage of the transistor, and determining a gate threshold voltage of the transistor based on the measured drain-to-source voltage of the transistor. The method may include one or more of the following additional elements or steps in any combination and in any suitable order. Element 1: generating a voltage-measure signal based on the drain-to-source voltage of the transistor. Element 2: wherein regulating the gate-to-source voltage comprises driving a gate terminal of the transistor based on a comparison of a gate voltage to the voltage-measure signal. Element 3: converting an analog value of the voltage-measure signal into a digital signal.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A measurement circuit, comprising:
a current source configured to provide a current to a drain terminal of a transistor;
a voltage-measure circuit configured to measure a drain-to-source voltage of the transistor; and
a regulator circuit configured to:
receive from the voltage-measure circuit a voltage-measure signal indicative of the drain-to-source voltage of the transistor; and
regulate a gate-to-source voltage of the transistor based on the drain-to-source voltage of the transistor.

2. The measurement circuit of claim 1, wherein the regulator circuit is configured to regulate the gate-to-source voltage of the transistor to be equal to the drain-to-source voltage of the transistor.

3. The measurement circuit of claim 1, wherein the regulator circuit comprises an enable input and is configured to regulate the gate-to-source voltage of the transistor based on the drain-to-source voltage of the transistor in response to an enable signal received at the enable input.

4. The measurement circuit of claim 3, wherein the voltage-measure signal corresponds to a gate threshold voltage of the transistor when the regulator circuit is enabled.

5. The measurement circuit of claim 4, wherein the voltage-measure signal corresponds to an on-state drain-to-source voltage of the transistor when the transistor is driven in an on-state and the regulator circuit is disabled.

6. The measurement circuit of claim 1, wherein the regulator circuit comprises:
a reference input coupled to receive the voltage-measure signal;
an gate-drive output coupled to a gate terminal of the transistor; and
a feedback input coupled to the gate terminal of the transistor; and
wherein the regulator circuit is configured to drive the gate terminal of the transistor based on a comparison of the reference input to the feedback input.

7. The measurement circuit of claim 1, further comprising an analog-to-digital converter coupled to the voltage-measure circuit and configured to output a digital signal corresponding to an analog value of the voltage-measure signal.

8. An inverter circuit, comprising:
a plurality of transistors configured to drive an electric motor;
a gate drive circuit including a plurality of gate drivers configured to respectively drive the plurality of transistors during an operating phase of the inverter circuit; and
a measurement circuit configured to measure a gate threshold voltage of a transistor from among the plurality of transistors during an initialization phase of the inverter circuit, wherein the measurement circuit comprises:
a current source configured to provide a current to a drain terminal of the transistor;
a voltage-measure circuit configured to measure a drain-to-source voltage of the transistor; and
a regulator circuit configured to:
receive from the voltage-measure circuit a voltage-measure signal indicative of the drain-to-source voltage of the transistor; and
regulate a gate-to-source voltage of the transistor based on the drain-to-source voltage of the transistor.

9. The inverter circuit of claim 8, wherein:
the inverter circuit includes a plurality of measurement circuits; and
each of the plurality of measurement circuits is configured to measure the gate threshold voltage of a respective one of the plurality of transistors during the initialization phase of the inverter circuit.

10. The inverter circuit of claim 8, wherein each transistor of the plurality of transistors comprises a silicon-carbide (SiC) metal-oxide semiconductor field-effect transistor (MOSFET).

11. The inverter circuit of claim 8, wherein the regulator circuit comprises:
a reference input coupled to receive the voltage-measure signal;
an gate-drive output coupled to a gate terminal of the transistor; and
a feedback input coupled to the gate terminal of the transistor; and
wherein the regulator circuit is configured to drive the gate terminal of the transistor based on a comparison of the reference input to the feedback input.

12. A method, comprising:
providing a current to a drain terminal of a transistor;
measuring a drain-to-source voltage of the transistor;
regulating a gate-to-source voltage of the transistor based on the drain-to-source voltage of the transistor; and
determining a gate threshold voltage of the transistor based on the measured drain-to-source voltage of the transistor.

13. The method of claim 12, further comprising generating a voltage-measure signal based on the drain-to-source voltage of the transistor.

14. The method of claim 13, wherein regulating the gate-to-source voltage comprises driving a gate terminal of the transistor based on a comparison of a gate voltage to the voltage-measure signal.

15. The method of claim 13, further comprising converting an analog value of the voltage-measure signal into a digital signal.

## Amended claims

### Amended claims in accordance with Rule 137(2) EPC.

1. A measurement circuit (290), comprising:
a current source (312) configured to provide a current to a drain terminal (231) of a transistor (230);
a voltage-measure circuit (320) configured to measure a drain-to-source voltage of the transistor (230); and
a regulator circuit (330) configured to:
receive from the voltage-measure circuit (320) a voltage-measure signal indicative of the drain-to-source voltage of the transistor (230); and
regulate a gate-to-source voltage of the transistor (230) based on the drain-to-source voltage of the transistor (230).

2. The measurement circuit (290) of claim 1, wherein the regulator circuit (330) is configured to regulate the gate-to-source voltage of the transistor (230) to be equal to the drain-to-source voltage of the transistor (230).

3. The measurement circuit (290) of claim 1, wherein the regulator circuit (330) comprises an enable input and is configured to regulate the gate-to-source voltage of the transistor (230) based on the drain-to-source voltage of the transistor (230) in response to an enable signal received at the enable input.

4. The measurement circuit (290) of claim 3, wherein the voltage-measure signal corresponds to a gate threshold voltage of the transistor (230) when the regulator circuit (330) is enabled.

5. The measurement circuit (290) of claim 4, wherein the voltage-measure signal corresponds to an on-state drain-to-source voltage of the transistor (230) when the transistor (230) is driven in an on-state and the regulator circuit (330) is disabled.

6. The measurement circuit (290) of claim 1, wherein the regulator circuit (330) comprises:
a reference input (331) coupled to receive the voltage-measure signal;
an gate-drive output (333) coupled to a gate terminal (233) of the transistor (230); and
a feedback input (332) coupled to the gate terminal (233) of the transistor (230); and
wherein the regulator circuit (330) is configured to drive the gate terminal (233) of the transistor (230) based on a comparison of the reference input (331) to the feedback input (332).

7. The measurement circuit (290) of claim 1, further comprising an analog-to-digital converter (340) coupled to the voltage-measure circuit (320) and configured to output a digital signal corresponding to an analog value of the voltage-measure signal.

8. An inverter circuit (204), comprising:
a plurality of transistors (230, 240, 250, 260, 270, 280) configured to drive an electric motor (206);
a gate drive circuit (220) including a plurality of gate drivers (221, 222) configured to respectively drive the plurality of transistors (230, 240, 250, 260, 270, 280) during an operating phase of the inverter circuit (204); and
a measurement circuit (290) configured to measure a gate threshold voltage of a transistor from among the plurality of transistors (230, 240, 250, 260, 270, 280) during an initialization phase of the inverter circuit (204), wherein the measurement circuit (290) is a measurement circuit (290) according to claim 1.

9. The inverter circuit (204) of claim 8, wherein:
the inverter circuit (204) includes a plurality of measurement circuits (290a, 290b, 290c, 290d, 290e, 290f); and
each of the plurality of measurement circuits (290a, 290b, 290c, 290d, 290e, 290f) is configured to measure the gate threshold voltage of a respective one of the plurality of transistors (230, 240, 250, 260, 270, 280) during the initialization phase of the inverter circuit (204).

10. The inverter circuit (204) of claim 8, wherein each transistor of the plurality of transistors (230, 240, 250, 260, 270, 280) comprises a silicon-carbide (SiC) metal-oxide semiconductor field-effect transistor (MOSFET).

11. The inverter circuit (204) of claim 8, wherein the regulator circuit (330) comprises:
a reference input (331) coupled to receive the voltage-measure signal;
an gate-drive output (333) coupled to a gate terminal (233) of the transistor (230); and
a feedback input (332) coupled to the gate terminal (233) of the transistor (230); and
wherein the regulator circuit (330) is configured to drive the gate terminal (233) of the transistor (230) based on a comparison of the reference input (331) to the feedback input (332).

12. A method (500), comprising:
providing a current to a drain terminal of a transistor (502);
measuring a drain-to-source voltage of the transistor (504);
regulating a gate-to-source voltage of the transistor based on the drain-to-source voltage of the transistor (506); and
determining a gate threshold voltage of the transistor based on the measured drain-to-source voltage of the transistor (508).

13. The method (500) of claim 12, further comprising generating a voltage-measure signal based on the drain-to-source voltage of the transistor.

14. The method (500) of claim 13, wherein regulating the gate-to-source voltage comprises driving a gate terminal of the transistor based on a comparison of a gate voltage to the voltage-measure signal.

15. The method (500) of claim 13, further comprising converting an analog value of the voltage-measure signal into a digital signal (510).
